# EUROPEAN PATENT SPECIFICATION

(11) **EP 3 832 289 B1**
(45) Date of publication and mention of the grant of the patent: **21.10.2026**
(21) Application number: 20212302.2
(22) Date of filing: 07.12.2020
(51) Int. Cl.: G01N 17/00

(54) **DETERMINING PRESENCE OF INTERNAL CORROSION WITHIN A ROTOR BLADE BY MEASURING MAGNETIC CHARACTERISTIC(S)**
BESTIMMUNG DER ANWESENHEIT VON INNERER KORROSION IN EINER ROTORSCHAUFEL DURCH MESSUNG VON MAGNETISCHEN EIGENSCHAFTEN
DÉTERMINATION DE LA PRÉSENCE DE CORROSION INTERNE À L'INTÉRIEUR D'UNE PALE DE ROTOR PAR LA MESURE DE CARACTÉRISTIQUE(S) MAGNÉTIQUE(S)

(30) Priority: 06.12.2019 US 201916706211
(43) Date of publication of application: 09.06.2021
(73) Proprietor: RTX Corporation, Farmington, CT 06032 (US)
(72) Inventor: LIU, Xuan, Glastonbury, CT 06033 (US); OUYANG, Zhong, Glastonbury, CT 06033 (US); DEBICCARI, Andrew, North Branford, CT 06471 (US); LORICCO, Nicholas M., Agawarn, MA 01001 (US); BRINDLEY, William J., Hebron, CT 06248 (US); MACAULEY, Kathryn, Glastonbury, CT 06033 (US); BISCHOF, Christopher J., Southlake, TX 76092 (US)
(74) Representative: Dehns

(56) References cited:
- DE-A1- 102004 030 501
- US-A1- 2005 200 355
- US-A1- 2014 091 785
- OUYANG ZHONG ET AL: "Simulation of a Permeability Probe to Estimate Hot Corrosion Zone Size", 27 September 2019 (2019-09-27), XP093042899, Retrieved from the Internet <URL:https://www.comsol.com/paper/download/679761/li_acdc_presentation.pdf> [retrieved on 20230428]

## Description

### BACKGROUND OF THE DISCLOSURE

### 1. Technical Field

This disclosure relates generally to inspection methods and, more particularly, to measuring magnetic characteristic(s) of a component.

### 2. Background Information

Various methods are known in the art for inspecting components such as rotor blades of a gas turbine engine. Typically, for aircraft applications, these known methods require a gas turbine engine to be removed from a wing of an aircraft and at least partially disassembled such that a rotor blade may be removed and discretely inspected. Removing a gas turbine engine from an aircraft and disassembling that engine, however, is time consuming and expensive. There is a need in the art therefore for improved methods capable of decreasing time and expense for inspection of gas turbine engine components, particularly those components housed within a case of the gas turbine engine.

US 2005/200355 A1 discloses a prior art method according to the preamble of claim 1.

### SUMMARY OF THE DISCLOSURE

According to an aspect, a method is provided according to claim 1.

Features of embodiments of the invention are set forth in the dependent claims.

The present disclosure may include any one or more of the features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a schematic illustration of an inspection system inspecting a component within rotational equipment.
FIG. 2 is a flow diagram of a method involving rotational equipment.
FIG. 3 is a schematic illustration of a measurement probe measuring magnetic characteristic(s) of a component within the rotational equipment.
FIG. 4 is another schematic illustration of the measurement probe measuring magnetic characteristic(s) of the component within the rotational equipment.
FIG. 5 is a flow diagram of another method involving rotational equipment.
FIG. 6 is a side cutaway illustration of a geared turbine engine.

### DETAILED DESCRIPTION

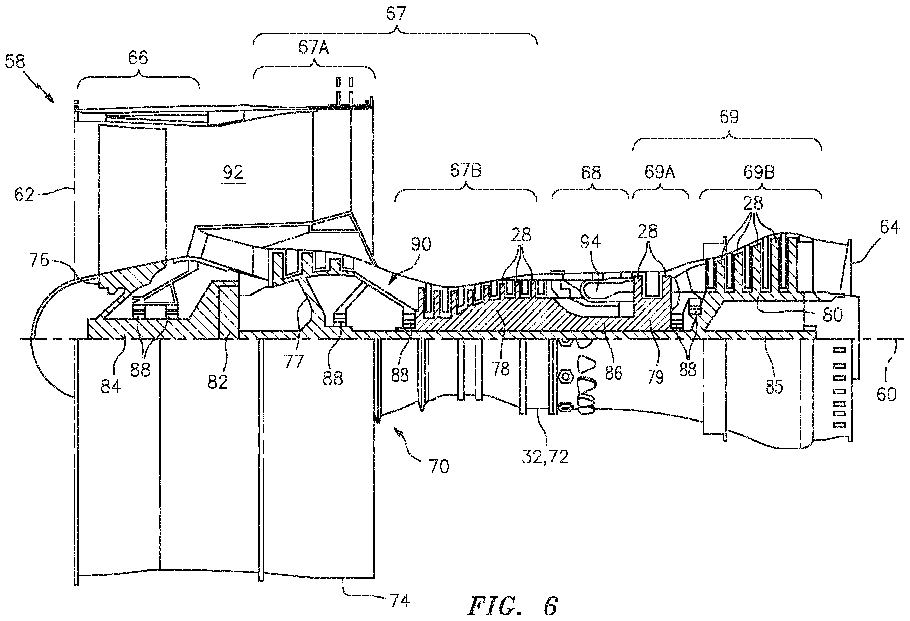

The present disclosure includes systems and methods for at least inspecting one or more components within rotational equipment. An example of such rotational equipment is a gas turbine engine for an aircraft propulsion system, an exemplary embodiment of which is described below in further detail with respect to FIG. 6. The inspection system of the present disclosure, however, is not limited to such an aircraft application nor a gas turbine engine application. The inspection system, for example, may alternatively inspect one or more components within rotational equipment such as, but not limited to, an industrial gas turbine engine, a wind turbine or a water turbine.

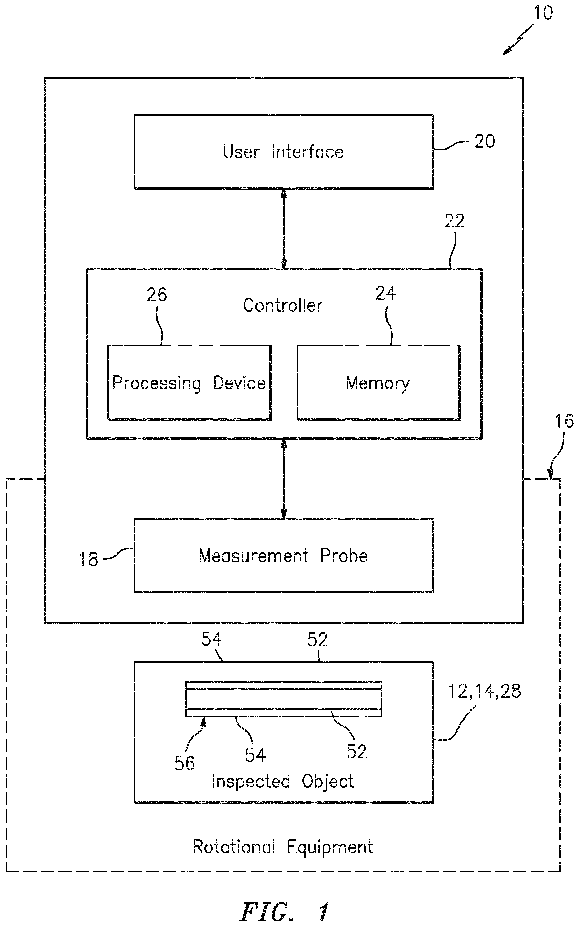

FIG. 1 illustrates an inspection system 10 configured for measuring at least one magnetic characteristic of at least one object 12. Here, the object 12 may be one of the components 14 within the rotational equipment 16. The magnetic characteristic is relative magnetic permeability.

The inspection system 10 of FIG. 1 includes a measurement probe 18, a user interface 20 and a controller 22. The measurement probe 18 is configured to sense the at least one magnetic characteristic. The measurement probe 18 is further configured to output probe data that is indicative of the sensed at least one magnetic characteristic. The measurement probe 18, for example, may be configured as a magnetometer that senses magnetic permeability of material and outputs probe data indicative of the sensed magnetic permeability. Various types and configurations of magnetometers and other suitable measurement probes are known in the art, and the present disclosure is not limited to any particular ones thereof.

The user interface 20 is configured to communicate information to a user; e.g., a human operator. The user interface 20, for example, may be operable to visually present the information and/or audibly present the information to the user. Examples of the user interface 20 include, but are not limited to, a display screen, a touch screen, a speaker or a combination thereof.

The controller 22 is configured in signal communication (e.g., hardwired and/or wirelessly coupled) with the measurement probe 18 and the user interface 20. The controller 22 may be implemented with a combination of hardware and software. The hardware may include memory 24 and at least one processing device 26, which processing device 26 may include one or more single-core and/or multi-core processors. The hardware may also or alternatively include analog and/or digital circuitry other than that described above.

The memory 24 is configured to store software (e.g., program instructions) for execution by the processing device 26, which software execution may control and/or facilitate performance of one or more operations such as those described in the methods below. The memory 24 may be a non-transitory computer readable medium. For example, the memory 24 may be configured as or include a volatile memory and/or a nonvolatile memory. Examples of a volatile memory may include a random access memory (RAM) such as a dynamic random access memory (DRAM), a static random access memory (SRAM), a synchronous dynamic random access memory (SDRAM), a video random access memory (VRAM), etc. Examples of a nonvolatile memory may include a read only memory (ROM), an electrically erasable programmable read-only memory (EEPROM), a computer hard drive, etc.

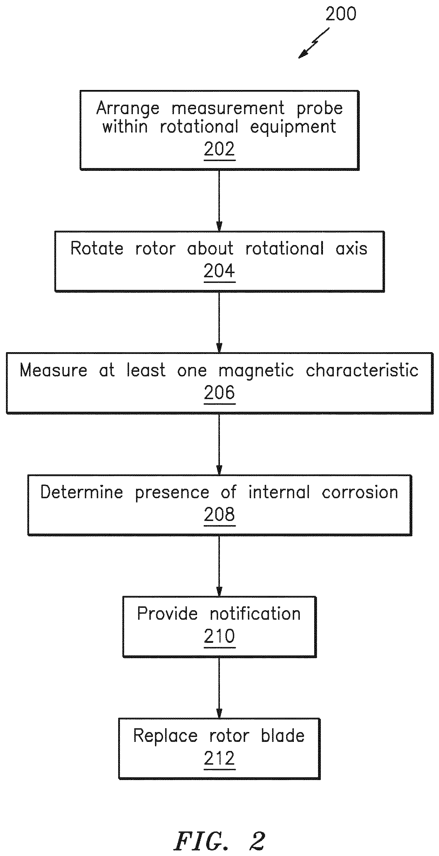

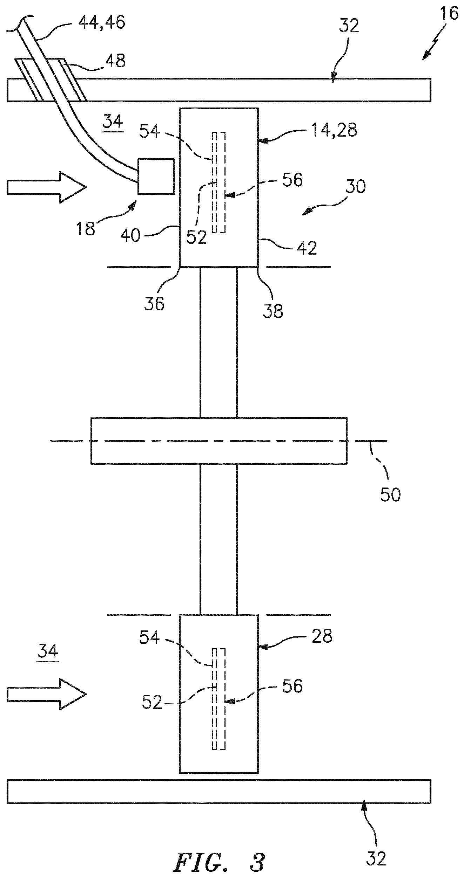

FIG. 2 is a flow diagram of a method 200 involving the rotational equipment 16. During this method, at least one of the components 14 within the rotational equipment 16 is inspected, for example, to determine if the rotational equipment component(s) 14 are suitable (e.g., acceptable and/or meet a minimum threshold) for continued service / use within the rotational equipment 16. For ease of description, referring to FIG. 3, the components 14 are described below as rotor blades 28 in a rotor blade array of a rotor 30 positioned within a case 32 of the rotational equipment 16. The method 200, however, is not limited to such an exemplary application.

The method 200 may be performed using an inspection system such as the inspection system 10 of FIG. 1. The method 200, of course, may alternatively be performed using other inspection systems and/or inspection devices.

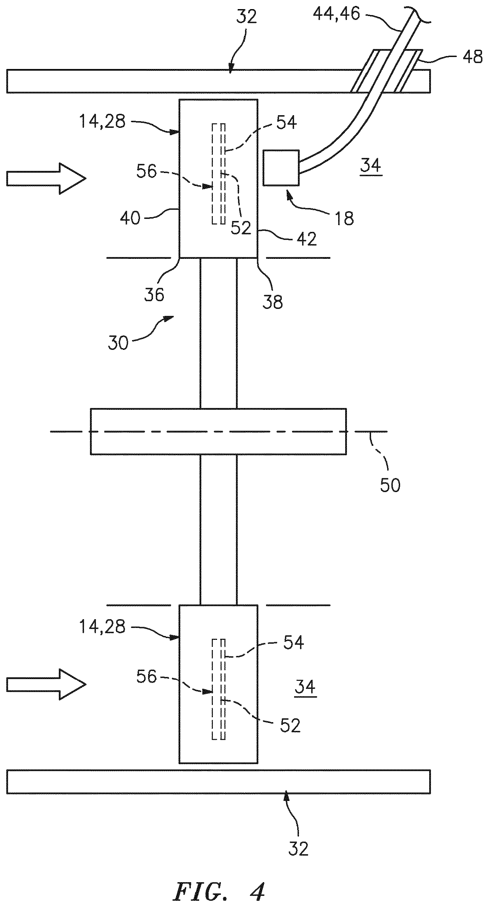

In step 202, the measurement probe 18 is arranged within the rotational equipment 16. The measurement probe 18, for example, may be arranged inside of the case 32 and next to the rotor 30. The measurement probe 18 of FIG. 3, for example, is located within an interior cavity 34 of the case 32 (e.g., within an annular flowpath of the rotational equipment 16) and at (e.g., on, adjacent or proximate) an upstream end 36 (or alternatively a downstream end 38; see FIG. 4) of the rotor 30. With this arrangement, the measurement probe 18 may be arranged at a leading edge 40 (or alternatively a trailing edge 42; see FIG. 4) of a respective one of the rotor blades 28 being investigated.

To arrange the measurement probe 18 within the case 32, the measurement probe 18 may be configured with a probe positioning device 44. The measurement probe 18, for example, may be secured to an end portion of a borescope inspection tool such as, but not limited to, a borescope camera 46. A borescope plug may be removed from a borescope inspection port 48 in the case 32, and the probe positioning device 44 may be inserted into the borescope inspection port 48 to arrange the measurement probe 18 as described above. The borescope camera 46 may be used to visually locate the measurement probe 18 at a probe inspection position within the case 32. Of course, other tools and/or methodologies may be utilized to arrange the measurement probe 18 within the case 32.

In step 204, the rotor 30 is rotated about its rotational axis 50 such that a respective one of the rotor blades 28 to be inspected (hereinafter "inspected rotor blade") is located next to the measurement probe 18. Alternatively, this step 204 may be skipped where, for example, the inspected rotor blade 28 is already located next to the measurement probe 18, or the measurement probe 18 is initially arranged to be located next to the inspected rotor blade 28.

In step 206, at least one magnetic characteristic of the inspected rotor blade 28 is measured. The controller 22, for example, may signal the measurement probe 18 to measure / sense magnetic permeability of material forming at least a portion of the inspected rotor blade 28. The measurement probe 18 may then output probe data indicative of the measured magnetic characteristic(s) to the controller 22 for further processing. The output probe data may also be communicated to a server and/or another storage device for archiving, statistical analysis, etc.

In step 208, presence of internal corrosion 52 within the inspected rotor blade 28 is determined. The controller 22, for example, processes the output data received from the measurement probe 18 to determine whether or not there is a minimum threshold of corrosion 52 within the rotor blade 28; e.g., a sign of internal corrosion 52.

The determination of the presence of internal corrosion 52 is facilitated by the phenomena that the magnetic permeability of rotor blade material may change as that material itself undergoes changes. For example, material of the inspected rotor blade 28 that forms a wall 54 of an internal passage 56 within that rotor blade 28 may be subject to corrosion 52 resulting from an interaction between the rotor blade material and cooling fluid (e.g., cooling air) flowing through the internal passage 56 during operation of the rotational equipment 16. Such internal corrosion 52 causes a change in the chemical composition of the rotor blade material. Such a change in the chemical composition of the rotor blade material may in turn cause a change in the magnetic permeability of the rotor blade material. For example, internal corrosion within a metal superalloy (e.g., a nickel superalloy) rotor blade may change (e.g., increase) the magnetic permeability of the rotor blade material. In other words, the internal corrosion 52 may make the rotor blade material more ferromagnetic.

Utilizing the relationship between material changes and magnetic characteristic changes, the controller 22 may determine whether or not there is any or a minimum threshold (e.g., a sign) of internal corrosion 52 within the inspected rotor blade 28. The controller 22, for example, may compare the probe data and, more particularly, a value associated with the measured magnetic characteristic to a corrosion threshold. Where the measured magnetic characteristic value is equal to or greater than (or less than depending upon the specific magnetic characteristic) the corrosion threshold, the controller 22 may determine the presence of internal corrosion 52 within the inspected rotor blade 28. Conversely, where the measured magnetic characteristic value is less than (or greater than depending upon the specific magnetic characteristic) the corrosion threshold, the controller 22 may determine there is no, or an acceptable amount of, internal corrosion 52 within the inspected rotor blade 28.

Where internal corrosion 52 is detected within the inspected rotor blade 28, the controller 22 may further determine if the inspected rotor blade 28 is suitable for continued service within the rotational equipment 16. For example, where the measured magnetic characteristic value is equal to or greater than (or less than depending upon the specific magnetic characteristic) a replacement threshold, the controller 22 may determine that the inspected rotor blade 28 is no longer suitable for continued service within the rotational equipment 16; e.g., the inspected rotor blade 28 should be replaced. This replacement threshold may correspond to an amount of internal corrosion 52 that removes the inspected rotor blade 28 from of its design specification or allowed deviation therefrom. However, where the measured magnetic characteristic value is less than (or greater than depending upon the specific magnetic characteristic) the replacement threshold, the controller 22 may determine that the inspected rotor blade 28 is still suitable for continued service within the rotational equipment 16. Of course, the inspection system 10 may also predict a continued useful life for the inspected rotor blade 28 based on the specific measured magnetic characteristic value; e.g., by comparing that value to one or more intermediate thresholds.

In step 210, a notification is provided. For example, where it is determined that internal corrosion 52 is present within the inspected rotor blade 28, a positive indication for internal corrosion 52 may be presented to a user by the user interface 20. However, where it is determined that no, or an acceptable amount of, internal corrosion 52 is present within the inspected rotor blade 28, a negative indication for internal corrosion 52 may be presented to the user by the user interface 20. In addition or alternatively, where it is determined that inspected rotor blade 28 is no longer suitable for continued use within the rotational equipment 16, an indication that the inspected rotor blade 28 should be replaced may be presented to the user by the user interface 20. However, where it is determined that inspected rotor blade 28 is still suitable for continued use within the rotational equipment 16, an indication that the inspected rotor blade 28 does not need to be replaced may be presented to the user by the user interface 20.

In step 212, the inspected rotor blade 28 may be replaced where, for example, an indication is provided that internal corrosion 52 is present and/or the inspected rotor blade 28 is no longer suitable for service. Where the rotor blade 28 is replaced, the rotational equipment 16 may be partially disassembled.

One or more of the foregoing method steps may be repeated for one or more of the remaining rotor blades 28 of the rotor 30. For example, while the measurement probe 18 is still arranged within the case 32, the rotor 30 may be rotated about its rotational axis 50 such that a circumferentially neighboring rotor blade 28 is now arranged next to the measurement probe 18 for inspection. The steps 206, 208, 210 and/or 212 may be repeated for this neighboring rotor blade 28. This process may be continued iteratively until, for example, each rotor blade 28 in the rotor blade array has been inspected for internal corrosion 52. Alternatively, the process may be performed for a certain set of the rotor blades 28 (e.g., every other rotor blade 28, every third rotor blade 28, etc.) where, for example, a test sample is taken.

In some embodiments, the measurement probe 18 may be maintained in the same stationary position for the entire inspecting of a respective rotor blade 28. However, in other embodiments, the magnetic characteristic(s) may be measured at a plurality of different locations along the inspected rotor blade 28; e.g., at a plurality of locations along the leading and/or trailing edge 40, 42 of the inspected rotor blade 28. In still other embodiments, the magnetic characteristic(s) may be measured while the measurement probe 18 is slowly moved along the inspected rotor blade 28 to, for example, map the presence of internal corrosion 52 within the inspected rotor blade 28.

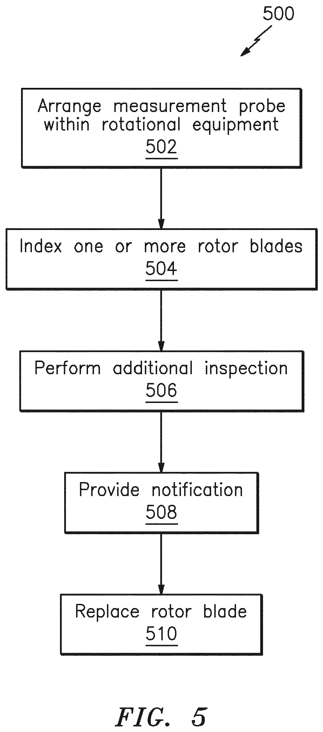

FIG. 5 is a flow diagram of another method 500 involving the rotational equipment 16. In step 502, the measurement probe 18 is arranged within the rotational equipment 16, for example, as described above with respect to the step 202.

In step 504, one or more of the rotor blades 28 are indexed. The rotor 30, for example, may be rotated about its rotational axis 50 and iteratively / repeatedly stopped such that one or more or each of the rotor blades 28 in the rotor blade array is momentarily located and stationary at the measurement probe 18. While each respective rotor blade 28 is stationary next to the measurement probe 18, the inspection system 10 is operated to determine whether or not there is any sign of internal corrosion 52 within that rotor blade 28 at or near the investigated rotor blade portion; e.g., see the steps 206 and 208 above. The controller 22 may then track which rotor blade(s) 28 has signs of internal corrosion 52 and/or which rotor blade(s) 28 have no signs of internal corrosion 52. Those rotor blades 28 that have signs of internal corrosion 52 are identified (e.g., digitally marked) for further inspection.

In step 506, an additional (e.g., more in depth) inspection is performed for each of the rotor blade(s) 28 identified as having signs of internal corrosion 52. For example, the magnetic characteristic(s) in one or more additional portions of each of those rotor blades 28 may be measured to determine how much corrosion 52 is present within the internal passage(s) 56 using a similar process as described above with respect to the steps 206 and 208. The internal corrosion 52 may also be mapped for one or more or each of the rotor blades 28.

In step 508, a notification may be provided for each of the rotor blades 28 which undergoes the additional inspection. This notification may be provided as describe above in the step 210.

In step 510, the inspected rotor blade(s) 28 may be replaced where, for example, an indication is provided that the inspected rotor blade(s) 28 is/are no longer suitable for continued service. Where the rotor blade(s) 28 are replaced, the rotational equipment 16 may be partially disassembled.

In some embodiments, the rotational equipment 16 may be configured as a gas turbine engine. In such embodiments, the rotor blades 28 may be configured as compressor blades within a compressor section of the gas turbine engine. Alternatively, the rotor blades 28 may be configured as turbine blades within a turbine section of the gas turbine engine.

In some embodiments, the methods 200 and/or 500 may be performed while the gas turbine engine is still configured with an aircraft. The methods 200 and/or 500, for example, may be performed while the gas turbine engine is still on wing; e.g., mounted to a wing of the aircraft. This enables the rotor blades 28 within the gas turbine engine to be inspected without costly and time consuming engine removal and/or disassembly processes. Furthermore, by reducing the cost and time for rotor blade inspections, such inspections may be performed more frequently without significantly disrupting scheduling for the aircraft.

FIG. 6 is a side cutaway illustration of a geared turbine engine 58 which may include the rotor blades 28. This turbine engine 58 extends along an axial centerline 60 (e.g., the rotational axis 50) between an upstream airflow inlet 62 and a downstream exhaust 64. The turbine engine 58 includes a fan section 66, a compressor section 67, a combustor section 68 and a turbine section 69. The compressor section 67 includes a low pressure compressor (LPC) section 67A and a high pressure compressor (HPC) section 67B. The turbine section 69 includes a high pressure turbine (HPT) section 69A and a low pressure turbine (LPT) section 69B.

The engine sections 66-69 are arranged sequentially along the centerline 60 within an engine housing 70. This housing 70 includes an inner case 72 (e.g., a core case) and an outer case 74 (e.g., a fan case). The inner case 72 may house one or more of the engine sections 67-69; e.g., an engine core. The inner case 72 may be configured as or otherwise include the case 32. The outer case 74 may house at least the fan section 66.

Each of the engine sections 66, 67A, 67B, 69A and 69B includes a respective rotor 76-80; e.g., the rotor 30 of FIG. 3 or 4. Each of these rotors 76-80 includes a plurality of rotor blades (e.g., the rotor blades 28) and one or more rotor disks, where the rotor blades are respectively arranged circumferentially around and connected to the respective rotor disk. The rotor blades 28, for example, may be formed integral with or mechanically fastened, welded, brazed, adhered and/or otherwise attached to the respective rotor disk(s).

The fan rotor 76 is connected to a gear train 82, for example, through a fan shaft 84. The gear train 82 and the LPC rotor 77 are connected to and driven by the LPT rotor 80 through a low speed shaft 85. The HPC rotor 78 is connected to and driven by the HPT rotor 79 through a high speed shaft 86. The shafts 84-86 are rotatably supported by a plurality of bearings 88; e.g., rolling element and/or thrust bearings. Each of these bearings 88 is connected to the engine housing 70 by at least one stationary structure such as, for example, an annular support strut.

During operation, air enters the turbine engine 58 through the airflow inlet 62. This air is directed through the fan section 66 and into a core gas path 90 and a bypass gas path 92. The core gas path 90 extends sequentially through the engine sections 67A-69B. The air within the core gas path 90 may be referred to as "core air". The bypass gas path 92 extends through a bypass duct, which bypasses the engine core. The air within the bypass gas path 92 may be referred to as "bypass air".

The core air is compressed by the compressor rotors 77 and 78 and directed into a combustion chamber 94 of a combustor in the combustor section 68. Fuel is injected into the combustion chamber 94 and mixed with the compressed core air to provide a fuel-air mixture. This fuel air mixture is ignited and combustion products thereof flow through and sequentially cause the turbine rotors 79 and 80 to rotate. The rotation of the turbine rotors 79 and 80 respectively drive rotation of the compressor rotors 78 and 77 and, thus, compression of the air received from a core airflow inlet. The rotation of the turbine rotor 80 also drives rotation of the fan rotor 76, which propels bypass air through and out of the bypass gas path 92. The propulsion of the bypass air may account for a majority of thrust generated by the turbine engine 58, e.g., more than seventy-five percent (75%) of engine thrust. The turbine engine 58 of the present disclosure, however, is not limited to the foregoing exemplary thrust ratio.

The case 32 and the rotor 30 of FIGS. 3 and 4 may be included in various turbine engines other than the one described above as well as in other types of rotational equipment. The case 32 and the rotor 30, for example, may be included in a geared turbine engine where a gear train connects one or more shafts to one or more rotors in a fan section, a compressor section and/or any other engine section. Alternatively, the case 32 and the rotor 30 may be included in a turbine engine configured without a gear train. The case 32 and the rotor 30 may be included in a geared or non-geared turbine engine configured with a single spool, with two spools (e.g., see FIG. 6), or with more than two spools. The turbine engine may be configured as a turbofan engine, a turbojet engine, a propfan engine, a pusher fan engine or any other type of turbine engine. The present disclosure therefore is not limited to any particular types or configurations of turbine engines or rotational equipment.

While various embodiments of the present disclosure have been described, it will be apparent to those of ordinary skill in the art that many more embodiments and implementations are possible within the scope of the claims.

## Claims

1. A method involving rotational equipment (16) that includes a case (32) and a first rotor blade (28) within the case (32), the method comprising:
arranging a probe (18) within the case (32) adjacent the first rotor blade (28);
measuring a magnetic characteristic of the first rotor blade (28) using the probe (18);
determining presence of internal corrosion within the first rotor blade (28) based on the measured magnetic characteristic ,
**characterised in that**:
- determining presence of internal corrosion comprises comparing the measured magnetic characteristic to a corrosion threshold, wherein the magnetic characteristic comprises relative magnetic permeability; and
- determining suitability of the first rotor blade (28) for continued service within the rotational equipment (16) by comparing the measured magnetic characteristic to a replacement threshold.

2. The method of claim 1, further comprising providing a magnetometer that comprises the probe (18).

3. The method of claim 1 or 2, wherein the probe (18) is located adjacent a leading edge (40) of the first rotor blade (28), and the measuring comprises measuring the magnetic characteristic of at least a portion of the first rotor blade (28) along the leading edge (40).

4. The method of claim 1 or 2, wherein the probe (18) is located adjacent a trailing edge (42) of the first rotor blade (28), and the measuring comprises measuring the magnetic characteristic of at least a portion of the first rotor blade (28) along the trailing edge (42).

5. The method of any preceding claim, further comprising:
rotating a rotor (30) of the rotational equipment (16) at least until a second rotor blade (28) is adjacent the probe (18);
measuring a second magnetic characteristic of the second rotor blade (28) using the probe (18); and
determining presence of internal corrosion within the second rotor blade (28) based on the measured second magnetic characteristic.

6. The method of any preceding claim, wherein the internal corrosion comprises corrosion within an internal passage (56) of the first rotor blade (28).

7. The method of any preceding claim, wherein the rotational equipment (16) is a gas turbine engine.

8. The method of claim 7, wherein the gas turbine engine is installed with an aircraft during the measuring of the magnetic characteristic of the first rotor blade (28).

9. The method of any preceding claim, wherein the first rotor blade (28) is configured as a turbine blade.

10. The method of any preceding claim, further comprising:
moving the probe (18) along the first rotor blade (28);
measuring magnetic characteristics at different regions along the first rotor blade (28) using the probe (18); and
determining presence of internal corrosion within the first rotor blade (28) at one or more of the different regions based on the measured magnetic characteristics.

11. The inspection method of claim 1 for rotational equipment (16) that includes the case (32) and a rotor (30) within the case (32), the inspection method comprising:
arranging the probe (18) within the case (32) adjacent the rotor (30);
rotating the rotor (30) about an axis (50), wherein the rotor (30) includes an array of rotor blades (28);
measuring the magnetic characteristic for each rotor blade (28) in the array of rotor blades using the probe (18); and
determining whether or not there is internal corrosion within each rotor blade (28) in the array of rotor blades based on the measured magnetic characteristic.

12. The inspection method of claim 11, further comprising further inspecting a first rotor blade (28) in the array of rotor blades where the first rotor blade (28) was determined to have internal corrosion.

13. The inspection method of claim 11 or 12, wherein:
the rotational equipment (16) is a gas turbine engine for an aircraft propulsion system, and the gas turbine engine is configured on wing during the measuring of the magnetic characteristic; and/or
the probe (18) is part of a magnetometer.

14. The method of claim 1, comprising a magnetometer that includes the probe (18).

15. The method of claim 14, wherein the probe (18) of the magnetometer is connected to an end of a borescope tool (46).

## Patentansprüche

1. Verfahren, das Rotationsausrüstung (16) betrifft, die ein Gehäuse (32) und eine erste Rotorschaufel (28) innerhalb des Gehäuses (32) beinhaltet, wobei das Verfahren umfasst:
Anordnen einer Sonde (18) innerhalb des Gehäuses (32) benachbart zu der ersten Rotorschaufel (28);
Messen einer magnetischen Eigenschaft der ersten Rotorschaufel (28) unter Verwendung der Sonde (18);
Bestimmen von Vorhandensein von innerer Korrosion innerhalb der ersten Rotorschaufel (28) basierend auf der gemessenen magnetischen Eigenschaft,
**dadurch gekennzeichnet, dass**:
- Bestimmen von Vorhandensein von innerer Korrosion Vergleichen der gemessenen magnetischen Eigenschaft mit einem Korrosionsschwellenwert umfasst, wobei die magnetische Eigenschaft relative magnetische Permeabilität umfasst; und
- Bestimmen von Eignung der ersten Rotorschaufel (28) für Weiterbetrieb innerhalb der Rotationsausrüstung (16) durch Vergleichen der gemessenen magnetischen Eigenschaft mit einem Austauschschwellenwert.

2. Verfahren nach Anspruch 1, ferner umfassend Bereitstellen eines Magnetometers, das die Sonde (18) umfasst.

3. Verfahren nach Anspruch 1 oder 2, wobei die Sonde (18) benachbart zu einer Vorderkante (40) der ersten Rotorschaufel (28) angeordnet ist und das Messen Messen der magnetischen Eigenschaft von mindestens einem Abschnitt der ersten Rotorschaufel (28) entlang der Vorderkante (40) umfasst.

4. Verfahren nach Anspruch 1 oder 2, wobei die Sonde (18) benachbart zu einer Hinterkante (42) der ersten Rotorschaufel (28) angeordnet ist und das Messen Messen der magnetischen Eigenschaft von mindestens einem Abschnitt der ersten Rotorschaufel (28) entlang der Hinterkante (42) umfasst.

5. Verfahren nach einem der vorhergehenden Ansprüche, ferner umfassend:
Drehen eines Rotors (30) der Rotationsausrüstung (16), mindestens bis eine zweite Rotorschaufel (28) benachbart zu der Sonde (18) ist;
Messen einer zweiten magnetischen Eigenschaft der zweiten Rotorschaufel (28) unter Verwendung der Sonde (18); und
Bestimmen von Vorhandensein von innerer Korrosion innerhalb der zweiten Rotorschaufel (28) basierend auf der gemessenen zweiten magnetischen Eigenschaft.

6. Verfahren nach einem der vorhergehenden Ansprüche, wobei die innere Korrosion Korrosion innerhalb eines Innenkanals (56) der ersten Rotorschaufel (28) umfasst.

7. Verfahren nach einem der vorhergehenden Ansprüche, wobei die Rotationsausrüstung (16) ein Gasturbinenmotor ist.

8. Verfahren nach Anspruch 7, wobei der Gasturbinenmotor während des Messens der magnetischen Eigenschaft der ersten Rotorschaufel (28) an einem Luftfahrzeug installiert ist.

9. Verfahren nach einem der vorhergehenden Ansprüche, wobei die erste Rotorschaufel (28) als eine Turbinenschaufel ausgelegt ist.

10. Verfahren nach einem der vorhergehenden Ansprüche, ferner umfassend:
Bewegen der Sonde (18) entlang der ersten Rotorschaufel (28);
Messen von magnetischen Eigenschaften an verschiedenen Bereichen entlang der ersten Rotorschaufel (28) unter Verwendung der Sonde (18); und
Bestimmen von Vorhandensein von innerer Korrosion innerhalb der ersten Rotorschaufel (28) an einem oder mehreren der verschiedenen Bereiche basierend auf den gemessenen magnetischen Eigenschaften.

11. Inspektionsverfahren nach Anspruch 1 für Rotationsausrüstung (16), die das Gehäuse (32) und einen Rotor (30) innerhalb des Gehäuses (32) beinhaltet, wobei das Inspektionsverfahren umfasst:
Anordnen der Sonde (18) innerhalb des Gehäuses (32) benachbart zu dem Rotor (30);
Drehen des Rotors (30) um eine Achse (50), wobei der Rotor (30) eine Rotorschaufelanordnung (28) beinhaltet;
Messen der magnetischen Eigenschaft für jede Rotorschaufel (28) in der Rotorschaufelanordnung unter Verwendung der Sonde (18); und
Bestimmen, ob innere Korrosion innerhalb jeder Rotorschaufel (28) in der Rotorschaufelanordnung vorliegt oder nicht, basierend auf der gemessenen magnetischen Eigenschaft.

12. Inspektionsverfahren nach Anspruch 11, ferner umfassend weiteres Inspizieren einer ersten Rotorschaufel (28) in der Rotorschaufelanordnung, bei der bestimmt wurde, dass die erste Rotorschaufel (28) innere Korrosion aufweist.

13. Inspektionsverfahren nach Anspruch 11 oder 12, wobei:
die Rotationsausrüstung (16) ein Gasturbinenmotor für ein Antriebssystem eines Luftfahrzeugs ist und der Gasturbinenmotor während des Messens der magnetischen Eigenschaft im eingebauten Zustand ist; und/oder
die Sonde (18) Teil eines Magnetometers ist.

14. Verfahren nach Anspruch 1, umfassend ein Magnetometer, das die Sonde (18) beinhaltet.

15. Verfahren nach Anspruch 14, wobei die Sonde (18) des Magnetometers mit einem Ende eines Boroskopwerkzeugs (46) verbunden ist.

## Revendications

1. Procédé impliquant un équipement rotatif (16) qui comporte un boîtier (32) et une première pale de rotor (28) à l'intérieur du boîtier (32), le procédé comprenant :
l'agencement d'une sonde (18) à l'intérieur du boîtier (32) adjacent à la première pale de rotor (28) ;
la mesure d'une caractéristique magnétique de la première pale de rotor (28) à l'aide de la sonde (18) ;
la détermination de la présence de corrosion interne à l'intérieur de la première pale de rotor (28) sur la base de la caractéristique magnétique mesurée,
**caractérisé en ce que** :
- la détermination de la présence de corrosion interne comprend la comparaison de la caractéristique magnétique mesurée à un seuil de corrosion, dans lequel la caractéristique magnétique comprend la perméabilité magnétique relative ; et
- la détermination de l'aptitude de la première pale de rotor (28) à continuer à servir à l'intérieur de l'équipement rotatif (16) en comparant la caractéristique magnétique mesurée à un seuil de remplacement.

2. Procédé selon la revendication 1, comprenant en outre la fourniture d'un magnétomètre qui comprend la sonde (18).

3. Procédé selon la revendication 1 ou 2, dans lequel la sonde (18) est située adjacente à un bord d'attaque (40) de la première pale de rotor (28), et la mesure comprend la mesure de la caractéristique magnétique d'au moins une partie de la première pale de rotor (28) le long du bord d'attaque (40).

4. Procédé selon la revendication 1 ou 2, dans lequel la sonde (18) est située adjacente à un bord de fuite (42) de la première pale de rotor (28), et la mesure comprend la mesure de la caractéristique magnétique d'au moins une partie de la première pale de rotor (28) le long du bord de fuite (42).

5. Procédé selon une quelconque revendication précédente, comprenant en outre :
la rotation d'un rotor (30) de l'équipement rotatif (16) au moins jusqu'à ce qu'une seconde pale de rotor (28) soit adjacente à la sonde (18) ;
la mesure d'une seconde caractéristique magnétique de la seconde pale de rotor (28) à l'aide de la sonde (18) ; et
la détermination de la présence de corrosion interne à l'intérieur de la seconde pale de rotor (28) sur la base de la seconde caractéristique magnétique mesurée.

6. Procédé selon une quelconque revendication précédente, dans lequel la corrosion interne comprend la corrosion à l'intérieur d'un passage interne (56) de la première pale de rotor (28).

7. Procédé selon une quelconque revendication précédente, dans lequel l'équipement rotatif (16) est un moteur à turbine à gaz.

8. Procédé selon la revendication 7, dans lequel le moteur à turbine à gaz est installé avec un aéronef pendant la mesure de la caractéristique magnétique de la première pale de rotor (28).

9. Procédé selon une quelconque revendication précédente, dans lequel la première pale de rotor (28) est configurée comme une pale de turbine.

10. Procédé selon une quelconque revendication précédente, comprenant en outre :
le déplacement de la sonde (18) le long de la première pale de rotor (28) ;
la mesure de caractéristiques magnétiques au niveau de différentes régions le long de la première pale de rotor (28) à l'aide de la sonde (18) ; et
la détermination de la présence de corrosion interne à l'intérieur de la première pale de rotor (28) au niveau d'une ou de plusieurs des différentes régions sur la base des caractéristiques magnétiques mesurées.

11. Procédé d'inspection selon la revendication 1 pour un équipement rotatif (16) qui comporte le boîtier (32) et un rotor (30) à l'intérieur du boîtier (32), le procédé d'inspection comprenant :
l'agencement de la sonde (18) à l'intérieur du boîtier (32) adjacente au rotor (30) ;
la rotation du rotor (30) autour d'un axe (50), dans lequel le rotor (30) comporte un ensemble de pales de rotor (28) ;
la mesure de la caractéristique magnétique pour chaque pale de rotor (28) dans le réseau de pales de rotor à l'aide de la sonde (18) ; et
le fait de déterminer s'il y a ou non de la corrosion interne à l'intérieur de chaque pale de rotor (28) dans l'ensemble de pales de rotor sur la base de la caractéristique magnétique mesurée.

12. Procédé d'inspection selon la revendication 11, comprenant en outre l'inspection supplémentaire d'une première pale de rotor (28) dans l'ensemble de pales de rotor lorsqu'il a été déterminé que la première pale de rotor (28) présentait une corrosion interne.

13. Procédé d'inspection selon la revendication 11 ou 12, dans lequel :
l'équipement rotatif (16) est un moteur à turbine à gaz pour un système de propulsion d'aéronef, et le moteur à turbine à gaz est configuré sur l'aile lors de la mesure de la caractéristique magnétique ; et/ou
la sonde (18) fait partie d'un magnétomètre.

14. Procédé selon la revendication 1, comprenant un magnétomètre qui comporte la sonde (18).

15. Procédé selon la revendication 14, dans lequel la sonde (18) du magnétomètre est connectée à une extrémité d'un outil endoscopique (46).
